(19) **Europäisches Patentamt / European Patent Office / Office européen des brevets**

(11) **EP 4 636 424 A1**

(12) **EUROPEAN PATENT APPLICATION**
published in accordance with Art. 153(4) EPC

(43) Date of publication:
**22.10.2025 Bulletin 2025/43**

(21) Application number: **23903480.4**

(22) Date of filing: **11.12.2023**

(51) International Patent Classification (IPC):
**G01R 31/52** *(2020.01)*

(52) Cooperative Patent Classification (CPC):
**G01R 31/50; G01R 31/52**

(86) International application number:
**PCT/JP2023/044242**

(87) International publication number:
**WO 2024/128194 (20.06.2024 Gazette 2024/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.12.2022 JP 2022199726**

(71) Applicants:
• **Hitachi Industrial Equipment Systems Co., Ltd.**
  **Tokyo 101-0021 (JP)**
• **Chino Corporation**
  **Tokyo 173-8632 (JP)**

(72) Inventors:
• **YOSHIZAKI, Akio**
  **Tokyo 101-0021 (JP)**
• **ISHIBASHI, Shozo**
  **Tokyo 173-8632 (JP)**
• **NEMOTO, Masanobu**
  **Tokyo 101-0021 (JP)**
• **IDE, Yu**
  **Tokyo 173-8632 (JP)**

(74) Representative: **MERH-IP Matias Erny Reichl Hoffmann**
**Patentanwälte PartG mbB**
**Paul-Heyse-Straße 29**
**80336 München (DE)**

(54) **INSULATION MONITORING APPARATUS, AND INSULATION MONITORING METHOD**

(57) An insulation monitoring apparatus is an insulation monitoring apparatus that monitors a leakage current relating to a switching device that controls power that is supplied from a power supply to a load, includes a leakage current acquisition unit that acquires a leakage current value detected by a leakage current detection unit provided in at least one of between the switching device and the load, and between the switching device and a primary side, a primary side voltage acquisition unit that acquires a power supply voltage value that is a voltage value of the power supply, and a period identifying unit that identifies an on period that is a period in which power is supplied to the load by the switching device, wherein a period in which the power is not supplied to the load by the switching device is defined as an off period, and the insulation monitoring apparatus further includes an estimation unit that estimates a normalized leakage current value that is an effective value of the leakage current value when the on period is 100% with reference to the power supply voltage value, based on the leakage current value in the on period.

FIG. 3

INSULATION MONITORING APPARATUS — 1

- PERIOD IDENTIFYING UNIT — 11
- LEAKAGE CURRENT ACQUISITION UNIT — 12
- PRIMARY SIDE VOLTAGE ACQUISITION UNIT — 13
- ESTIMATION UNIT — 14
- NOTIFICATION UNIT — 15

**Description**

[Technical Field]

The present invention relates to an insulation monitoring apparatus and an insulation monitoring method.

[Background Art]

In order to safely operate industrial equipment, it is necessary to maintain specified insulation performance. Since the insulation performance may be degraded due to deterioration of the material or the like over time, it is desirable to periodically evaluate the insulation performance. Patent Literature 1 discloses a circuit breaker characterized by including a switch unit that connects and disconnects a load current of a main circuit, a load current detection unit that detects a magnitude of the load current, and a leakage current detection unit that detects a magnitude of a leakage current of the load current.

[Citation List]

[Patent Literature]

[Patent Literature 1] Japanese Patent Laid-Open No. 2005-304148

[Summary of Invention]

[Technical Problem]

In the invention described in Patent Literature 1, there is room for improvement in a method for calculating a leakage current.

[Solution to Problem]

An insulation monitoring apparatus according to a first aspect of the present invention is an insulation monitoring apparatus that monitors a leakage current relating to a switching device that controls power that is supplied from a power supply to a load, and includes a leakage current acquisition unit that acquires a leakage current value detected by a leakage current detection unit provided in at least one of between the switching device and the load, and between the switching device and a primary side, a primary side voltage acquisition unit that acquires a power supply voltage value that is a voltage value of the power supply, and a period identifying unit that identifies an on period that is a period in which power is supplied to the load by the switching device, wherein a period in which power is not supplied to the load by the switching device is defined as an off period, and the insulation monitoring apparatus further includes an estimation unit that estimates a normalized leakage current value that is an effective value of the leakage current value when the on period is 100% with reference to the power supply voltage value, based on the leakage current value in the on period.

An insulation monitoring method according to a second aspect of the present invention is an insulation monitoring method executed by an insulation monitoring apparatus that monitors a leakage current relating to a switching device that controls power that is supplied from a power supply to a load, and includes a leakage current detection step of acquiring a leakage current value detected by a leakage current detection unit provided in at least one of between the switching device and the load, and between the switching device and a primary side, a primary side voltage acquisition step of acquiring a power supply voltage value that is a voltage value of the power supply, and a period identifying step of identifying an on period that is a period in which power is supplied to the load by the switching device, wherein a period in which power is not supplied to the load by the switching device is defined as an off period, and the insulation monitoring method further includes an estimation step of estimating a normalized leakage current value that is an effective value of the leakage current value when the on period is 100%, with reference to the power supply voltage value, based on the leakage current value in the on period.

[Advantageous Effects of Invention]

According to the present invention, it is possible to accurately calculate a leakage current.

[Brief Description of Drawings]

[Figure 1] Figure 1 is a hardware configuration diagram of an insulation monitoring system in a first embodiment.

[Figure 2] Figure 2 is a hardware configuration diagram of an insulation monitoring apparatus.

[Figure 3] Figure 3 is a functional block diagram of the insulation monitoring apparatus.

[Figure 4] Figure 4 is a diagram explaining an operation of the insulation monitoring apparatus.

[Figure 5] Figure 5 is a flowchart showing frequency determination processing.

[Figure 6] Figure 6 is a flowchart showing measurement processing.

[Figure 7] Figure 7 is a hardware configuration diagram of an insulation monitoring system in a second embodiment.

[Figure 8] Figure 8 is a hardware configuration diagram of an insulation monitoring system in a third embodiment.

[Figure 9] Figure 9 is a hardware configuration diagram of an insulation monitoring system in a modification of the third embodiment.

[Figure 10] Figure 10 is a hardware configuration diagram of an insulation monitoring system in a fourth embodiment.

[Figure 11] Figure 11 is a hardware configuration diagram of an insulation monitoring system in a modification of the fourth embodiment.

[Description of Embodiments]

-First Embodiment-

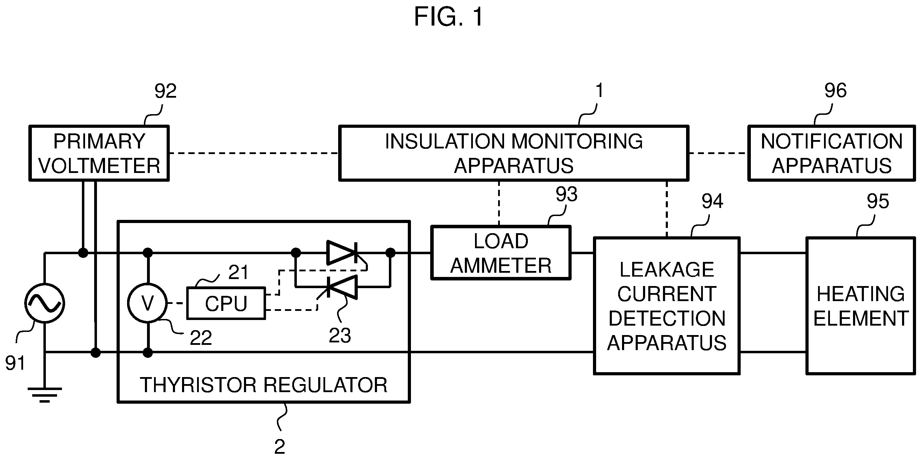

Hereinafter, a first embodiment of an insulation monitoring apparatus according to the present invention will be described with reference to Figure 1 to Figure 6.

Figure 1 is a hardware configuration diagram of an insulation monitoring system in the first embodiment. An insulation monitoring apparatus system 100 includes an insulation monitoring apparatus 1, a thyristor regulator 2 that is a switching device, a power supply 91, a primary voltmeter 92, a load ammeter 93, a leakage current detection apparatus 94, a heating element 95, and a notification apparatus 96. Note that in Figure 1, a solid line indicates a path of power, and a broken line indicates a path of a signal. However, since a current value and a voltage value may be used for transmission of a signal, power may flow in the path of a signal indicated by the broken line. Analog communication or a digital communication may be used for information transmission from the primary voltmeter 92, the load ammeter 93, and the leakage current detection apparatus 94 to the insulation monitoring apparatus 1. The digital communication is a Profibus, IEEE802.3, or the like.

Just to be clear, each of the primary voltmeter 92, the load ammeter 93, and the leakage current detection apparatus 94 may not be an apparatus that is independently used, and may not include a display unit, for example. The primary voltmeter 92 can also be referred to as "voltage measurement unit" or "voltage measurement module". The load ammeter 93 can also be referred to as "current measurement unit", or "current measurement module". The leakage current detection apparatus 94 can also be referred to as "leakage current measurement unit" or "leakage current measurement module".

The power supply 91 is an AC power supply that is to be an electric power source to the heating element 95. The power supply 91 is grounded. In the present embodiment, a side closer to the power supply 91 than the thyristor regulator 2 in the path of the power is referred to as "primary side", and a side closer to the heating element 95 than the thyristor regulator 2 is referred to as "secondary side". The primary voltmeter 92 measures a voltage on the primary side and outputs information thereof to the insulation monitoring apparatus 1. The primary voltmeter 92 measures a voltage at a high frequency, and the frequency of measurement is, for example, several times the power supply frequency or more. For example, when the power supply frequency is 50 Hz, the primary voltmeter 92 measures a voltage at 1 kHz or more.

The load ammeter 93 measures a current (hereinafter, referred to as "load current") flowing from the power supply 91 to the heating element 95 that is the load, and outputs the measured current value to the insulation monitoring apparatus 1. Since the load ammeter 93 repeats measurement, the insulation monitoring apparatus 1 can obtain a time-series current value, that is to say, a waveform of a current value as will be described later. The leakage current detection apparatus 94 measures the leakage current and outputs a measured leakage current value to the insulation monitoring apparatus 1. Since the leakage current detection apparatus 94 repeats measurement, the insulation monitoring apparatus 1 obtains a time-series leakage current value, that is to say, a waveform of the leakage current value as will be described later. Note that "leakage current" is also referred to as "leak current". In the present embodiment, the leakage current detection apparatus 94 measures a leakage current generated in the heating element 95. The leakage current detection apparatus 94 is, for example, a zero phase current transformer (Zero phase Current Transformer; ZCT).

The heating element 95 is coupled to the power supply 91 via the thyristor regulator 2 therebetween. In other words, the heating element 95 is placed on the secondary side of the thyristor regulator 2. The heating element 95 generates heat by being supplied with electric power. The heating element 95 has a period in which power is supplied and a period in which supply of power is interrupted by the operation of the thyristor regulator 2. Hereinafter, the period in which power is supplied will be referred to as "on period", and the period in which the supply of power is interrupted will be referred to as "off period". The notification apparatus 96 is an apparatus that notifies abnormality by using at least one of sound, vibration, light, and video, for example. The notification apparatus 96 is, for example, a speaker, a light, a liquid crystal display, or the like.

The thyristor regulator 2 includes a CPU 21, a voltmeter 22, and a thyristor 23. The CPU 21 develops and executes a program stored in a ROM not shown in a RAM not shown. The CPU 21 controls two thyristors 23 so that a temperature of the heating element 95 becomes a set temperature, for example. Specifically, the CPU 21 controls power supplied to the heating element 95 by applying a voltage to a gate terminal of the thyristor 23. The thyristor regulator 2 adopts a phase control method, and controls the thyristor 23 based on a timing at which the voltage of the power supply 91 measured by the voltmeter 22 passes through 0 V.

Various known methods can be used for the control of the thyristor 23 by the CPU 21. For example, the CPU 21 acquires output of a thermometer not shown provided in a vicinity of the heating element 95 and determines a range of a phase for applying a voltage to the gate terminal of the thyristor 23 based on a value obtained by multiplying a deviation from a target value by a predetermined gain. Then, the CPU 21 applies a gate terminal voltage of the thyristor 23 in the range of the phase determined just now with the timing at which the voltage of the power supply 91 exceeds 0 V and becomes positive as a zero degree.

The insulation monitoring apparatus 1 calculates a normalized leakage current based on outputs of the primary voltmeter 92, the load ammeter 93, and the leakage current detection apparatus 94. Details will be described later.

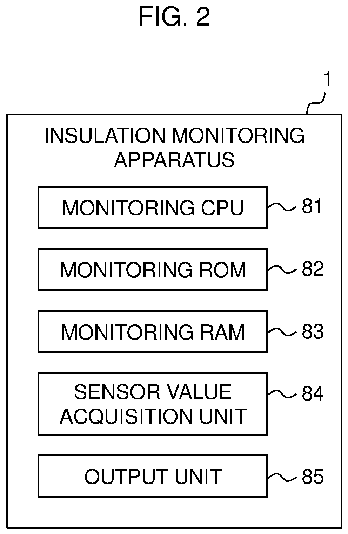

Figure 2 is a hardware configuration diagram of the insulation monitoring apparatus 1. The insulation monitoring apparatus 1 includes a monitoring CPU 81 that is a central processing unit, a monitoring ROM 82 that is a read-only storage apparatus, a monitoring RAM 83 that is a readable/writable storage apparatus, a sensor value acquisition unit 84 that acquires a measured value of a sensor, and an output unit 85.

The monitoring CPU 81 develops and executes a program that is stored in the monitoring ROM 82 in the monitoring RAM 83 to thereby perform various computations described later. The insulation monitoring apparatus 1 may be implemented by an FPGA (Field Programmable Gate Array) that is a logic circuit that can be rewritten and an ASIC (Application Specific Integrated Circuit) that is an integrated circuit for specific applications, instead of a combination of the monitoring CPU 81, the monitoring ROM 82, and the monitoring RAM 83. Furthermore, the insulation monitoring apparatus 1 may be implemented by a combination of different configurations, for example, a combination of the monitoring CPU 81, the monitoring ROM 82 and the monitoring RAM 83, and FPGA instead of the combination of the monitoring CPU 81, the monitoring ROM 82, and the monitoring RAM 83.

The sensor value acquisition unit 84 acquires the outputs of the primary voltmeter 92, the load ammeter 93, and the leakage current detection apparatus 94. The sensor value acquisition unit 84 has a hardware configuration corresponding to a communication method adopted by the primary voltmeter 92, the load ammeter 93, and the leakage current detection apparatus 94. For example, when the primary voltmeter 92 outputs the measured value by an analog signal of 4 to 20 mA, the sensor value acquisition unit 84 includes an AD converter. The output unit 85 outputs a signal to the notification apparatus 96 based on a computation result of the insulation monitoring apparatus 1. The output unit 85 has a hardware configuration that outputs a signal usable by the notification apparatus 96. For example, when the notification apparatus 96 is a light, the output unit 85 is a DA converter that outputs an operation signal to the light. For example, when the notification apparatus 96 is a liquid crystal display, the output unit 85 is a display control apparatus that outputs a video signal to the liquid crystal display.

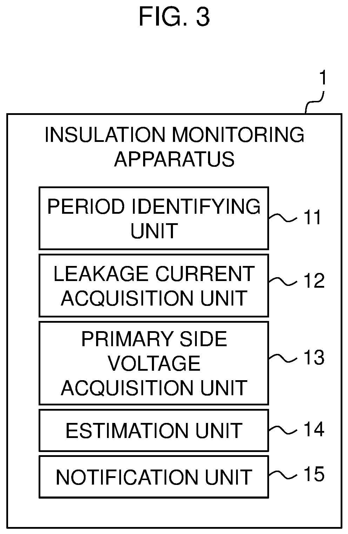

Figure 3 is a functional block diagram showing a function of the insulation monitoring apparatus 1. The insulation monitoring apparatus 1 includes a period identifying unit 11, a leakage current acquisition unit 12, a primary side voltage acquisition unit 13, an estimation unit 14, and a notification unit 15. The period identifying unit 11 identifies the off period that is a period in which supply of power to the heating element 95 is interrupted based on the output of the load ammeter 93. The period identifying unit 11 is implemented by computation performed by the monitoring CPU 81 and the sensor value acquisition unit 84.

The leakage current acquisition unit 12 acquires a leakage current value measured by the leakage current detection apparatus 94. The leakage current acquisition unit 12 is implemented by computation performed by the monitoring CPU 81 and the sensor value acquisition unit 84. Note that in the present embodiment, the leakage current is generated in the on period in which power is supplied to the heating element 95, but is not generated in the off period in which power is not supplied to the heating element 95. The on period and the off period are determined by the computation of the CPU 21 of the thyristor regulator 2, and at least the on period and the off period are not constant. Therefore, it is not possible to accurately estimate the degree of dielectric breakdown in the heating element 95 by only the magnitude of the leakage current value acquired by the leakage current acquisition unit 12.

The primary side voltage acquisition unit 13 acquires the primary side voltage value measured by the primary voltmeter 92. The primary side voltage acquisition unit 13 is implemented by computation performed by the monitoring CPU 81 and the sensor value acquisition unit 84. The estimation unit 14 calculates a normalized leakage current by using the leakage current value in the on period. The normalized leakage current is an effective value of the leakage current indicating the degree of the original dielectric breakdown when the on period is 100%, for example, an effective value of the leakage current that complements the off period when the on period and the off period are 1:1, that is, 50% each, and an effective value of the leakage current when the on period is 100% and there is no off period. In the present embodiment, the effective value of the leakage current in the case in which the on period is 100% and there is no off period is defined as the normalized leakage current.

The notification unit 15 outputs information on the normalized leakage current calculated by the estimation unit 14 to the notification apparatus 96. The notification unit 15 may directly output the value of the normalized leakage current, or may output a relationship with a threshold set in advance. For example, the notification unit 15 may classify the information on the normalized leakage current into any one of three stages of safe, caution, and danger depending on the relationship between two thresholds set in advance and the magnitude of the normalized leakage current, and may output a classification result by sound, video, light or the like.

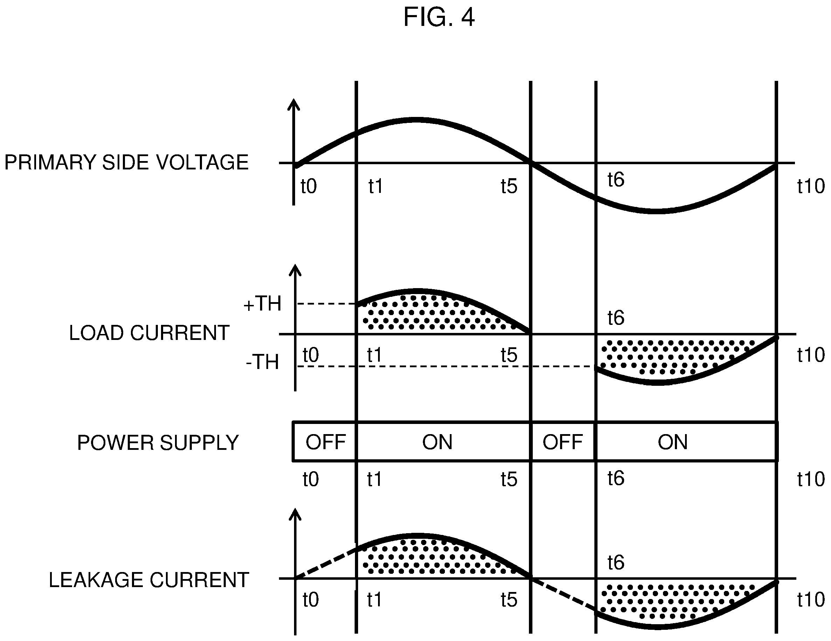

Figure 4 is a diagram explaining an operation of the insulation monitoring system. Figure 4 shows four time-series changes, which are changes of a primary side voltage measured by the primary voltmeter 92, a load current measured by the load ammeter 93, an off period and an on period identified by the period identifying unit 11, and a leakage current measured by the leakage current detection apparatus 94, in order from a top. Note that Figure 4 shows a case in which phases of the voltage and current correspond to each other. Furthermore, hatchings in Figure 4 are written to emphasize that measured values are present. A +TH and a -TH described in a graph of the load current are thresholds described later.

The monitoring CPU 81 samples the primary side voltage at a high speed, and can specify the timing at which the primary side voltage passes through 0 V. In Figure 4, the timing at which the primary side voltage crosses 0 V and goes from negative to positive is defined as a time point t0. Then, a timing at which the primary side voltage subsequently crosses 0 V and goes from positive to negative is defined as a time point t5, and a timing at which the primary side voltage further crosses 0 V next and goes from negative to positive is defined as a time point t10.

The load current shown in a second tier is zero until a time point t1 from the time point t0. The load current is measured as a certain magnitude at the time point t1, after which, it increases to be measured as a maximum value to thereafter decrease, and becomes zero at the time point t5. Thereafter, the load current is zero until a time point t6, decreases after being measured at the time point t6, increases after being measured as a minimum value to be zero again at the time point t10.

The period identifying unit 11 identifies the period until an absolute value of the load current becomes zero after exceeding a predetermined threshold TH as the on period, and identifies the other period than this, in other words, a period in which the absolute value of the load current is zero to less than the predetermined threshold as the off period. In other words, the period identifying unit 11 determines a time when the load current is out of a range of +TH to -TH as a start of the on period, and determines a time when the load current becomes zero for the first time thereafter as an end of the on period. In the example shown in Figure 4, as shown in a third tier, the period identifying unit 11 identifies a time period from the time point t0 to the time point t1, and a time period from the time point t5 to the time point t6 as the off periods, and identifies a time period from the time point t1 to the time point t5, and a time period from the time point t6 to the time point t10 as the on periods.

A leakage current shown in a fourth tier is a leakage current measured by the leakage current detection apparatus 94. In Figure 4, the time period from the time points t0 to t1 and the time period from the time points t5 to t6 are shown by broken lines, and the time period from the time points t1 to t5 and the time period from the time points t6 to t10 are shown by solid lines. In reality, the leakage currents measured by the leakage current detection apparatus 94 in the time period from the time points t0 to t1 and the time period from the time points t5 to t6 are values obtained by adding noise to zero. Since no electric power is supplied to the heating element 95 in the off period, the leakage current is not generated, but in the present embodiment, in order to calculate the normalized leakage current, the estimation unit 14 estimates the leakage current in the off period by the method described later. Furthermore, since it is not a true value but an apparent current that is measured, the effective value is calculated as will be described later. The leakage currents estimated by the estimation unit 14 are values as indicated by the broken lines.

(Processing of Estimation Unit 14)

The estimation unit 14 performs a Fourier transform on the leakage current value in the on period, and specifies a fundamental wave component. However, since the information on the leakage current value in the off period is absent, weighting in the off period is reduced by using a window function. In this Fourier transform, a vector of the primary side voltage is defined as a reference of a real number. The estimation unit 14 utilizes a magnitude and a phase of the fundamental wave component obtained by the Fourier transform for subsequent processing. For example, a case in which the leakage current value L1 is obtained as in the following formula 1 by the Fourier transform is considered. Note that in the formula 1, a DC component is omitted.

$$L1 = A_1 \cos(\omega t + \phi_1) + A_2 \cos(2\omega t + \phi_2) + \cdots \quad \text{(Formula 1)}$$

In this case, the estimation unit 14 calculates a normalized effective leakage current NE as in the following formula 2 by using $A_1$ that is a magnitude of a superficial leakage current, and a phase $\phi_1$.

$$NE = A_1 \cos(\phi_1) \quad \text{(Formula 2)}$$

(Flowchart)

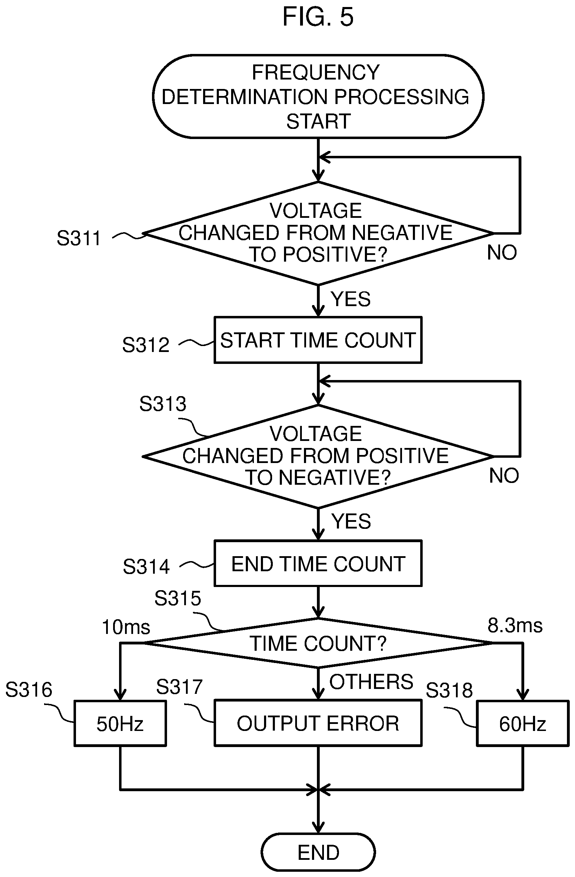

Figure 5 is a flowchart showing frequency determination processing executed by the estimation unit 14. The estimation unit 14 executes the frequency determination processing each time the power supply of the insulation monitoring apparatus 1 is turned on. In the frequency determination processing, the voltage on the primary side that is output by the primary voltmeter 92 is successively read and determined. In order to simplify the statement, statement of the processing of reading the output of the primary voltmeter 92 is omitted in Figure 5. Furthermore, frequency determination processing described below is on the premise that the power supply frequency is either 50 Hz or 60 Hz.

First, in step S311, the estimation unit 14 determines whether or not the primary side voltage changes from negative to positive. When determining that the primary side voltage does not change from negative to positive, the estimation unit 14 stays in step S311, and when determining that it changes from negative to positive, the estimation unit 14 proceeds to step S312. Although the power supply 91 is an AC power supply and the voltage changes in short time periods, the estimation unit 14 stands by until the voltage value becomes a specific state in step S311 since the phase of the voltage at the timing at which the frequency determination processing is started is indefinite.

In step S312, the estimation unit 14 starts time count and proceeds to step S313. In step S313, the estimation unit 14 determines whether or not the primary side voltage changes from positive to negative. When the estimation unit 14 determines that the primary side voltage does not change from positive to negative, it stays in step S313, and when the estimation unit 14 determines that the primary side voltage changes from positive to negative, it proceeds to step S314. In step S314, the estimation unit 14 ends the time count that is started in step S312.

In the subsequent step S315, the estimation unit 14 determines the value of the time count. When the estimation unit 14 determines that the time count is "10 ms", it proceeds to step S316 and determines the power supply frequency as "50 Hz". When the estimation unit 14 determines that the time count is "8.3 ms", it proceeds to step S318 and determines the power supply frequency as "60 Hz". When the estimation unit 14 determines that the time count is "other", that is, neither "10 ms" nor "8.3 ms", it proceeds to step S317 and outputs an error. When any of steps S316 to S318 is executed, the processing shown in Figure 5 is ended.

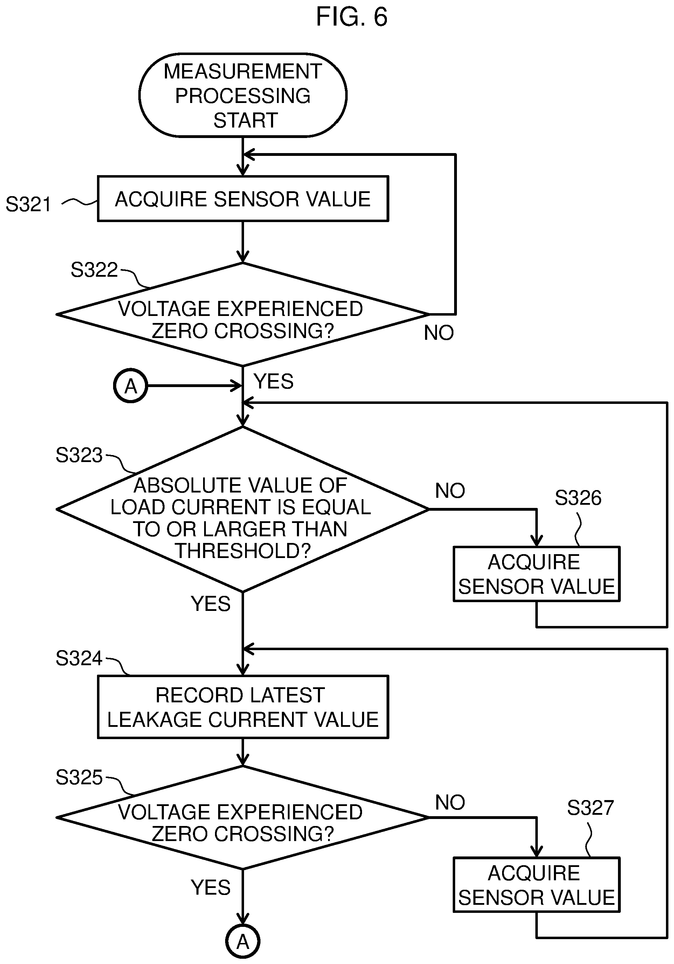

Figure 6 is a flowchart showing measurement processing executed by the estimation unit 14. The estimation unit 14 does not directly record the leakage current values acquired by the leakage current acquisition unit 12, but records only measured values in the on periods as described below. When the power supply of the insulation monitoring apparatus 1 is turned on, the estimation unit 14 executes measurement processing. Since the estimation unit 14 continues the measurement processing incessantly while the insulation monitoring apparatus 1 is started up, there is no end in Figure 6.

In step S321, the estimation unit 14 acquires sensor values, that is, the primary side voltage value output by the primary voltmeter 92, the load current value acquired by the period identifying unit 11, and the leakage current value acquired by the leakage current acquisition unit 12. In the subsequent step S322, the estimation unit 14 determines whether or not the primary side voltage experiences zero crossing. Zero crossing means that the positive and negative signs of the previous measured value and the current measured value differ from each other. Both a change from positive to negative and a change from negative to positive correspond to zero crossing. When determining that the primary side voltage value experiences zero crossing in step S322, the estimation unit 14 proceeds to step S323, and when determining that the primary side voltage value does not experience zero crossing, the estimation unit 14 returns to step S321. Step S322 corresponds to a state in which the estimation unit 14 waits for a zero crossing point of the voltage, for example, a timing of the time point t0 in Figure 4, when starting the first measurement.

In step S323, the estimation unit 14 determines whether or not the absolute value of the load current value that is acquired immediately before is equal to or larger than a predetermined threshold. When determining that the absolute value of the load current value is equal to or larger than the predetermined threshold, the estimation unit 14 proceeds to step S324, and when determining that the absolute value of the load current value is less than the predetermined threshold, the estimation unit 14 proceeds to step S326. In step S324, the estimation unit 14 records a latest leakage current value as the measured value of the on period and proceeds to step S325.

In step S325, the estimation unit 14 determines whether or not the acquired latest primary side voltage experiences zero crossing. When determining that the primary side voltage value experiences zero crossing in step S325, the estimation unit 14 returns to step S323 via circled A, and when determining that the primary side voltage value does not experience zero crossing, the estimation unit 14 proceeds to step S327.

In step S326, the estimation unit 14 acquires sensor values, that is, the primary side voltage value output by the primary voltmeter 92, the load current value acquired by the period identifying unit 11, and the leakage current value acquired by the leakage current acquisition unit 12 and returns to step S323. A loop of step S323 and step S326 waits for the start of the on period, and corresponds to processing of the time points t0 to t1, or the time points t5 to t6 in Figure 4. Note that to be accurate, the processing in step S323 and step S326 is executed by the period identifying unit 11.

In step S327, the estimation unit 14 acquires the sensor values, that is, the primary side voltage value output by the primary voltmeter 92, the load current value acquired by the period identifying unit 11, and the leakage current value acquired by the leakage current acquisition unit 12 and returns to step S324. The loop of step S323 and step S326 continues recording until the on period ends, and corresponds to the processing of the time points t1 to t5, or the time points t6 to t10 in Figure 4. Note that the case of affirmative determination being made in step S325 is in a state passing the time point t0 in Figure 4 again since a new measurement period is started, and therefore the case enters the loop of step S323 and step S326.

According to the aforementioned first embodiment, the following operational effects can be obtained.

(1) The insulation monitoring apparatus 1 monitors the leakage current relating to the thyristor regulator 2 that controls power that is supplied from the power supply 91 to the heating element 95 that is a load. The insulation monitoring apparatus 1 includes the leakage current acquisition unit 12 that acquires the leakage current value detected by the leakage current detection apparatus 94 provided between the thyristor regulator 2 and the heating element 95, the primary side voltage acquisition unit 13 that acquires the voltage value of the power supply, and the period identifying unit 11 that identifies the on period that is the period in which power is supplied to the load by the thyristor regulator 2. The period in which power is not supplied to the heating element 95 by the thyristor regulator 2 is defined as the off period. The insulation monitoring apparatus 1 includes the estimation unit 14 that estimates the normalized leakage current value that is the effective value of the leakage current value when the on period is 100% with the voltage value of the power supply as the reference, based on the leakage current value in the on period. Therefore, the insulation monitoring apparatus 1 can accurately calculate the leakage current.

(2) The estimation unit 14 performs Fourier transform with the leakage current value in the on period, and estimates the normalized leakage current value.

(3) The load that is to be supplied with power by the thyristor regulator 2 is the heating element 95. Since power supplied to the heating element 95 is turned on and off according to the target temperature, generation of the leak current is not uniform, and it is not easy to estimate the degree of dielectric breakdown. However, by using the method according to the present embodiment, it is possible to estimate the degree of dielectric breakdown based on the normalized leakage current value.

(4) The period identifying unit 11 identifies the on period based on the magnitude of the load current that is a current passing through the thyristor regulator 2. Therefore, special working is not required for the thyristor regulator 2.

(5) The notification unit 15 that gives notice based on the normalized leakage current value is included. Therefore, it is possible to notify the calculation result to the outside.

(Modification 1)

In the aforementioned first embodiment, the estimation unit 14 performs Fourier transform by using the leakage current value of the on period. However, the estimation unit 14 may estimate the leakage current value of the off period and perform Fourier transform by using the estimated leakage current value of the off period, and the measured leakage current value of the on period. For estimation of the leakage current value of the off period by the estimation unit 14, a linear expression approximate formula and a quadric expression approximate formula may be used, and when the on period is longer than the off period, mirror inversion may be used.

Estimation of the leakage current value by mirror inversion takes advantage of the fact that it is a neat sine wave or cosine wave if attention is paid to only the fundamental wave and utilizes the fact that it has symmetry. For example, when the off period is 0 to 30 degrees and the fundamental wave is a cosine wave, a value in 360 degrees to 330 degrees is used. Note that since the frequency of the fundamental wave is specified by the aforementioned frequency determination processing, the relationship between the time and the phase of the fundamental wave can be specified if the timing at which the leakage current value changes from negative to positive can be specified.

According to modification 1, the following operational effect can be obtained.

(6) The estimation unit 14 estimates the leakage current value in the off period, performs Fourier transform on the acquired leakage current value in the on period and the estimated leakage current value in the off period, and estimates the normalized leakage current value.

(Modification 2)

In the aforementioned first embodiment, the thyristor regulator 2 supplies power to the heating element 95. However, a destination to which the thyristor regulator 2 supplies power is not limited to the heating element 95. The destination to which the thyristor regulator 2 supplies power can be a device that consumes AC power, and various loads may be the supply destinations of power. Furthermore, the thyristor regulator 2 may supply power to the load via a step-up or step-down transformer. In this case, the leakage current detection apparatus 94 may be provided between the transformer and the load to evaluate the leakage current of only the load, or the leakage current detection apparatus 94 may be provided between the thyristor regulator 2 and the transformer to evaluate the leakage current of the transformer and the load.

(Modification 3)

In the aforementioned first embodiment, the insulation monitoring apparatus 1 is coupled to the notification apparatus 96, and the insulation monitoring apparatus 1 includes the notification unit 15. However, the insulation monitoring apparatus 1 does not have to include the notification unit 15. In this case, the insulation monitoring apparatus 1 may record the normalized effective leakage current that is the calculation result in a nonvolatile storage medium not shown with the time point and retrospectively read it or may output the calculation result by communication, for example.

(Modification 4)

In the aforementioned first embodiment, the load ammeter 93 is placed on the secondary side from the thyristor regulator 2, that is, on a side of the heating element 95. However, the load ammeter 93 may be placed on the primary side from the thyristor regulator 2, that is, a side of the power supply 91.

(Modification 5)

In the aforementioned first embodiment, the primary voltmeter 92 outputs the measured value to the insulation monitoring apparatus 1. However, the primary voltmeter 92 may not output the measured value itself to the insulation monitoring apparatus 1, but may output only timing signals of the timing at which the measured value changes from negative to positive, and the timing at which the measured value changes from positive to negative.

-Second Embodiment-

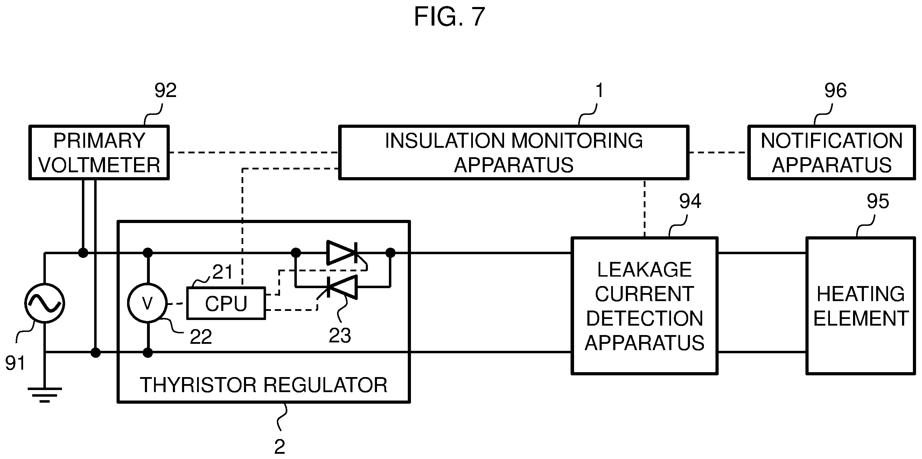

With reference to Figure 7, a second embodiment of the insulation monitoring system will be described. In the following explanation, the same components as those in the first embodiment are assigned with the same reference signs and a difference will be mainly described. Unexplained points in particular are the same as those in the first embodiment. The present embodiment differs from the first embodiment mainly in that a control signal is acquired from a thyristor regulator.

Figure 7 is a hardware configuration diagram of an insulation monitoring system in the second embodiment. A difference from the first embodiment is that a thyristor regulator 2 also outputs a control signal to a thyristor 23 to an insulation monitoring apparatus 1. Furthermore, in the present embodiment, the insulation monitoring system does not have to include a load ammeter 93. A CPU 21 of the thyristor regulator 2 also outputs a signal to the insulation monitoring apparatus 1 when starting and ending voltage application to a gate terminal of the thyristor 23.

A period identifying unit 11 of the insulation monitoring apparatus 1 identifies an on period and an off period based on a signal output by the CPU 21 of the thyristor regulator 2. Since other configurations and operations are similar to those in the first embodiment, explanation will be omitted.

According to the aforementioned second embodiment, the following operational effects can be obtained.

(7) The period identifying unit 11 identifies the on period based on the control signal output by the thyristor regulator 2. Therefore, the load ammeter 93 is not required, and the on period can be accurately grasped.

-Third Embodiment-

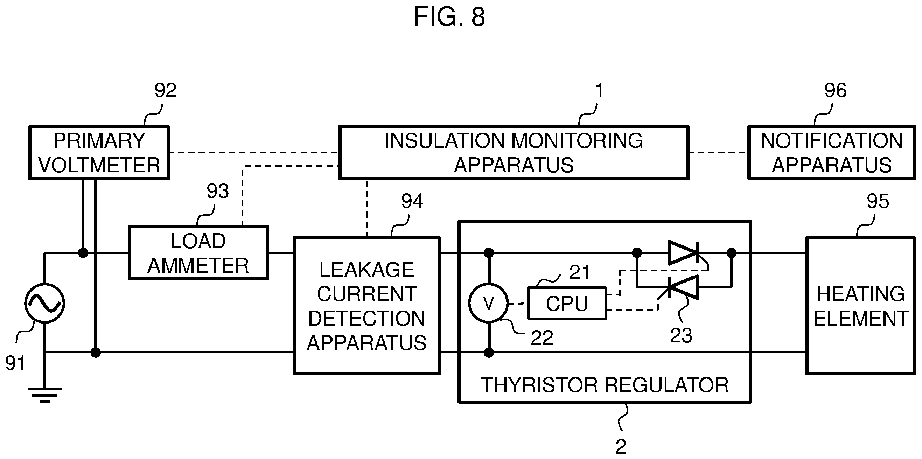

With reference to Figure 8, a third embodiment of the insulation monitoring system will be described. In the following explanation, the same components as those in the first embodiment are assigned with the same reference signs, and the difference will be mainly described. The points that are not particularly described are the same as those in the first embodiment. In the present embodiment, a position where a leakage current detection apparatus 94 that measures a leakage current mainly differs from that in the first embodiment.

Figure 8 is a hardware configuration diagram of an insulation monitoring system in the third embodiment. In Figure 8, the leakage current detection apparatus 94 is placed on a primary side from a thyristor regulator 2, that is, on a side of a power supply 91. Therefore, the leakage current detection apparatus 94 in the present embodiment measures a leakage current in not only a heating element 95 but also the thyristor regulator 2. In the first embodiment, the leakage current is generated in only the on period in which power is supplied to the heating element 95, and is not generated in the off period in which the power is not supplied to the heating element 95. However, in the present embodiment, a leakage current is likely to be also generated in the off period in which power is not supplied to the heating element 95. Note that in the present embodiment, the leakage current generated by the heating element 95 and the leakage current generated by a thyristor regulator 2 cannot be distinguished from each other. Since the configuration and operation of an insulation monitoring apparatus 1 are similar to those of the first embodiment, explanation will be omitted.

According to the aforementioned third embodiment, it is possible to adopt various hardware configurations.

(Modification of Third Embodiment)

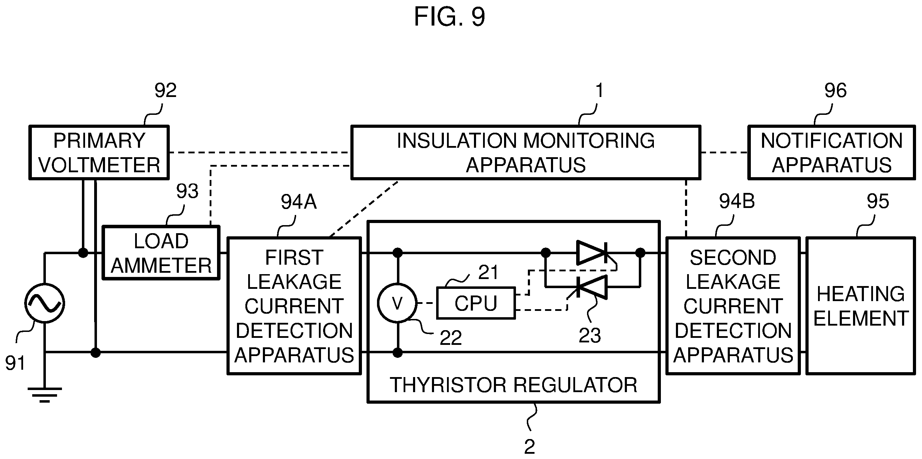

Figure 9 is a hardware configuration diagram of an insulation monitoring system in a modification of the third embodiment. When Figure 9 is compared with Figure 8, a first leakage current detection apparatus 94A is placed in a position of the leakage current detection apparatus 94 in Figure 8, and a second leakage current detection apparatus 94B is placed in the position of the leakage current detection apparatus 94 in Figure 1. The first leakage current detection apparatus 94A detects a total of a leakage current by a heating element 95 and a leakage current in a thyristor regulator 2 as in the third embodiment. The second leakage current detection apparatus 94B detects a leakage current in the heating element 95.

An estimation unit 14 of an insulation monitoring apparatus 1 calculates a normalized leakage current with respect to an output of each of the first leakage current detection apparatus 94A and the second leakage current detection apparatus 94B. A calculation method is similar to that of the first embodiment. Furthermore, a notification unit 15 of the insulation monitoring apparatus 1 notifies the output of each of the first leakage current detection apparatus 94A and the second leakage current detection apparatus 94B. Since other configurations and operations are similar to those in the first embodiment, explanation will be omitted.

In the present modification, the normalized leakage current value based on a measured value of the second leakage current detection apparatus 94B represents an insulation deterioration state of the heating element 95. Furthermore, a value obtained by subtracting the normalized leakage current value based on the measured value of the second leakage current detection apparatus 94B from the normalized leakage current value based on the measured value of the first leakage current detection apparatus 94A represents an insulation deterioration state of the thyristor regulator 2.

-Fourth Embodiment-

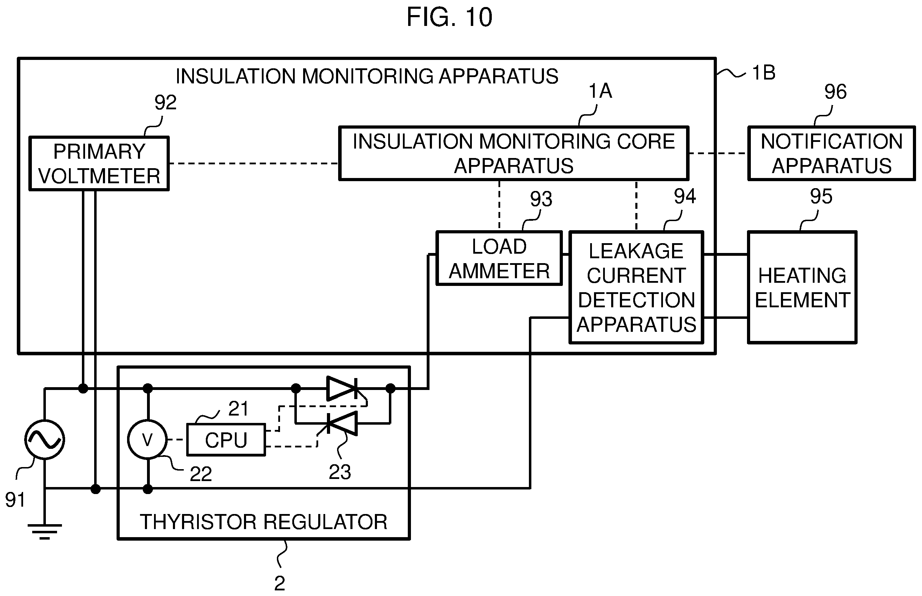

With reference to Figure 10, a fourth embodiment of the insulation monitoring system will be described. In the following explanation, the same components as those in the first embodiment are assigned with the same reference signs and a difference will be mainly described. Points that are not particularly described are the same as those in the first embodiment. The present embodiment differs from the first embodiment mainly in that the number of pieces of hardware constituting the insulation monitoring apparatus is increased.

Figure 10 is a hardware configuration diagram of an insulation monitoring system in the fourth embodiment. An insulation monitoring apparatus 1B includes an insulation monitoring core apparatus 1A corresponding to the insulation monitoring apparatus 1 in the first embodiment, a primary voltmeter 92, a load ammeter 93, and a leakage current detection apparatus 94. Operations of the primary voltmeter 92, the load ammeter 93, and the leakage current detection apparatus 94 are similar to those in the first embodiment. Configurations and operations of the insulation monitoring core apparatus 1A are similar to those of the insulation monitoring apparatus 1 in the first embodiment.

According to the aforementioned fourth embodiment, the following operational effects can be obtained.

(8) The insulation monitoring apparatus 1B includes the leakage current detection apparatus 94, the primary voltmeter 92 that measures the voltage value, and the load ammeter 93 that measures a load current. Therefore, insulation monitoring can be performed by only installing the insulation monitoring apparatus 1B with respect to an existing thyristor regulator 2.

(Modification of Fourth Embodiment)

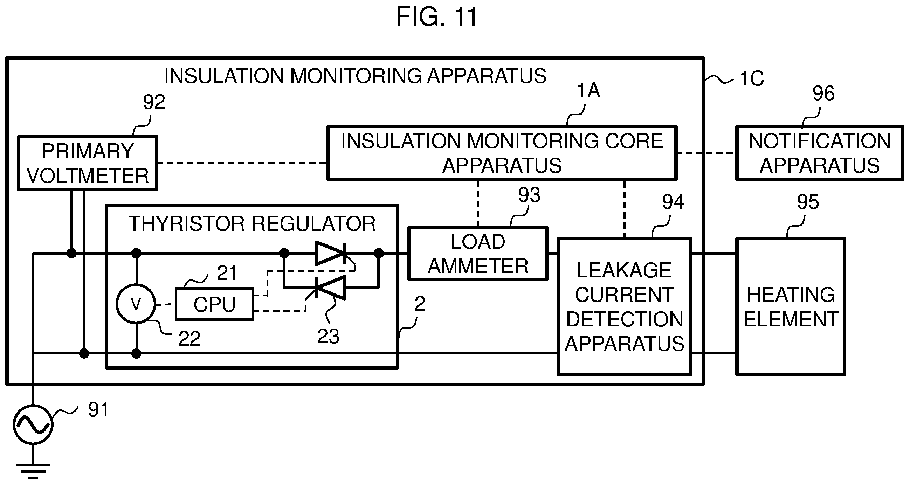

Figure 11 is a hardware configuration diagram of an insulation monitoring system in a modification of the fourth embodiment. When Figure 11 is compared with Figure 10, an insulation monitoring apparatus 1C further includes a thyristor regulator 2 in addition to a configuration of an insulation monitoring apparatus 1B. A configuration and operation of the thyristor regulator 2 are similar to those in the first embodiment.

According to the present modification, the following operational effect can be obtained.

(9) The insulation monitoring apparatus 1C includes the thyristor regulator 2. In other words, the insulation monitoring apparatus 1C is a thyristor regulator having an insulation monitoring function.

In the respective embodiments and modifications described above, the configurations of the functional blocks are only examples. Several functional configurations shown as separate functional blocks may be integrated, or configurations represented by one functional block diagram may be divided into two or more functions. Furthermore, some of the functions of the respective functional blocks may be configured to be included in other functional blocks.

In each of the embodiments and modifications described above, the program is stored in the ROM not shown, but the program may be stored in a rewritable nonvolatile memory. Furthermore, the insulation monitoring apparatus may include an input/output interface not shown, and the program may be read from another apparatus via a medium that is usable by the input/output interface and the insulation monitoring apparatus as necessary. Here, the medium refers to, for example, a storage medium attachable to and detachable from the input/output interface or a communication medium, that is, a wired, wireless, optical or other network, or a carrier wave or a digital signal that propagates through the network. Further, some or all of the functions implemented by the program may be implemented by a hardware circuit, or an FPGA.

The respective embodiments and modifications described above may be combined respectively. In the above description, various embodiments and modifications are described, but the present invention is not limited to these contents. Other aspects that can be considered within the scope of the technical idea of the present invention may also be included in the scope of the present invention. The object to which the present invention can be applied is not limited to the thyristor regulator, and the present invention can be applied to various switching devices that control load currents.

[Reference Signs List]

| | |
|---|---|
| 1, 1B, 1C | insulation monitoring apparatus |
| 2 | thyristor regulator |
| 11 | period identifying unit |
| 12 | leakage current acquisition unit |
| 13 | primary side voltage acquisition unit |
| 14 | estimation unit |
| 15 | notification unit |
| 94 | leakage current detection apparatus |
| 95 | heating element |

**Claims**

1. An insulation monitoring apparatus that monitors a leakage current relating to a switching device that controls power that is supplied from a power supply to a load, comprising:

   a leakage current acquisition unit that acquires a leakage current value detected by a leakage current detection unit provided in at least one of between the switching device and the load, and between the switching device and a primary side;
   a primary side voltage acquisition unit that acquires a power supply voltage value that is a voltage value of the power supply; and
   a period identifying unit that identifies an on period that is a period in which power is supplied to the load by the switching device,
   wherein a period in which power is not supplied to the load by the switching device is defined as an off period, the insulation monitoring apparatus further comprising an estimation unit that estimates a normalized leakage current value that is an effective value of the leakage current value when the on period is 100% with reference to the power supply voltage value, based on the leakage current value in the on period.

2. The insulation monitoring apparatus according to claim 1,
   wherein the estimation unit performs Fourier transform on the leakage current value in the on period, and estimates the normalized leakage current value.

3. The insulation monitoring apparatus according to claim 1,
   wherein the estimation unit estimates the leakage current value in the off period, performs Fourier transform on the acquired leakage current value in the on period and the estimated leakage current value in the off period, and estimates the normalized leakage current value.

4. The insulation monitoring apparatus according to claim 1,
   wherein the load is a heating element.

5. The insulation monitoring apparatus according to claim 1,
   wherein the period identifying unit identifies the on period based on a magnitude of a load current that is a current passing through the switching device.

6. The insulation monitoring apparatus according to claim 1,
   wherein the period identifying unit identifies the on period based on a control signal output by the switching device.

7. The insulation monitoring apparatus according to claim 5, further comprising:
   the leakage current detection unit, a voltmeter that measures the voltage value, and a load ammeter that measures the load current.

8. The insulation monitoring apparatus according to claim 6, further comprising:
   the leakage current detection unit, and a voltmeter that measures the voltage value.

9. The insulation monitoring apparatus according to claim 7, further comprising:
   the switching device.

10. The insulation monitoring apparatus according to claim 1, further comprising:
    a notification unit that gives notice based on the normalized leakage current value.

11. An insulation monitoring method executed by an insulation monitoring apparatus that monitors a leakage current relating to a switching device that controls power that is supplied from a power supply to a load, comprising:

    a leakage current detection step of acquiring a leakage current value detected by a leakage current detection unit provided in at least one of between the switching device and the load, and between the switching device and a primary side;
    a primary side voltage acquisition step of acquiring a power supply voltage value that is a voltage value of the power supply; and
    a period identifying step of identifying an on period that is a period in which power is supplied to the load by the switching device,
    wherein a period in which power is not supplied to the load by the switching device is defined as an off period,
    the insulation monitoring method comprising an estimation step of estimating a normalized leakage current value that is an effective value of the leakage current value when the on period is 100%, with reference to the power supply voltage value, based on the leakage current value in the on period.

**FIG. 1**

FIG. 1 — Block diagram showing: NOTIFICATION APPARATUS (96), HEATING ELEMENT (95), INSULATION MONITORING APPARATUS (1), LEAKAGE CURRENT DETECTION APPARATUS (94), LOAD AMMETER (93), PRIMARY VOLTMETER (92), THYRISTOR REGULATOR (2) with CPU (21), (22), (23), and power source (91).

FIG. 2

INSULATION MONITORING
APPARATUS
1

MONITORING CPU ～ 81

MONITORING ROM ～ 82

MONITORING RAM ～ 83

SENSOR VALUE
ACQUISITION UNIT ～ 84

OUTPUT UNIT ～ 85

# FIG. 3

1

**INSULATION MONITORING APPARATUS**

| | |
|---|---|
| PERIOD IDENTIFYING UNIT | 11 |
| LEAKAGE CURRENT ACQUISITION UNIT | 12 |
| PRIMARY SIDE VOLTAGE ACQUISITION UNIT | 13 |
| ESTIMATION UNIT | 14 |
| NOTIFICATION UNIT | 15 |

# FIG. 4

PRIMARY SIDE VOLTAGE

t0  t1  t5  t6  t10

LOAD CURRENT

+TH

-TH

t0  t1  t5  t6  t10

| POWER SUPPLY | OFF | ON | OFF | ON |

t0  t1  t5  t6  t10

LEAKAGE CURRENT

t0  t1  t5  t6  t10

EP 4 636 424 A1

## FIG. 5

```
        ┌─────────────────────────────┐
        │         FREQUENCY           │
        │ DETERMINATION PROCESSING    │
        │           START             │
        └─────────────────────────────┘
                      │
                      ▼ ◄──────────────────────┐
                   ╱──────────────────╲        │
                  ╱      VOLTAGE        ╲       │
   S311 ────────╱ CHANGED FROM NEGATIVE ╲──────┘
                ╲     TO POSITIVE?      ╱    NO
                  ╲──────────────────╱
                      │ YES
                      ▼
        ┌─────────────────────────────┐
   S312 │     START TIME COUNT        │
        └─────────────────────────────┘
                      │
                      ▼ ◄──────────────────────┐
   S313          ╱──────────────────╲          │
                ╱      VOLTAGE        ╲         │
               ╱ CHANGED FROM POSITIVE ╲───────┘
               ╲     TO NEGATIVE?      ╱   NO
                ╲──────────────────╱
                      │ YES
                      ▼
        ┌─────────────────────────────┐
   S314 │      END TIME COUNT         │
        └─────────────────────────────┘
   S315               │
   10ms               ▼                    8.3ms
       ╱──────────────────────────────╲
      ╱          TIME COUNT?           ╲
       ╲──────────────────────────────╱
        │          OTHERS │              │
   S316 │       S317      │      S318    │
        ▼                 ▼              ▼
   ┌─────────┐  ┌──────────────┐  ┌─────────┐
   │  50Hz   │  │ OUTPUT ERROR │  │  60Hz   │
   └─────────┘  └──────────────┘  └─────────┘
        │              │               │
        └──────────────┼───────────────┘
                       ▼
                 ┌───────────┐
                 │    END    │
                 └───────────┘
```

# FIG. 6

```
        ┌─────────────────────┐
        │    MEASUREMENT      │
        │    PROCESSING       │
        │      START          │
        └─────────────────────┘
```

S321 — ACQUIRE SENSOR VALUE

S322 — VOLTAGE EXPERIENCED ZERO CROSSING?   NO

Ⓐ → YES

S323 — ABSOLUTE VALUE OF LOAD CURRENT IS EQUAL TO OR LARGER THAN THRESHOLD?   NO   S326 — ACQUIRE SENSOR VALUE

YES

S324 — RECORD LATEST LEAKAGE CURRENT VALUE

S325 — VOLTAGE EXPERIENCED ZERO CROSSING?   NO   S327 — ACQUIRE SENSOR VALUE

YES

Ⓐ

FIG. 7

## FIG. 8

EP 4 636 424 A1

FIG. 9

EP 4 636 424 A1

FIG. 10

## FIG. 11

INSULATION MONITORING APPARATUS 1C

PRIMARY VOLTMETER 92

INSULATION MONITORING CORE APPARATUS 1A

NOTIFICATION APPARATUS 96

THYRISTOR REGULATOR

V

21 CPU

22

23

2

LOAD AMMETER 93

LEAKAGE CURRENT DETECTION APPARATUS 94

HEATING ELEMENT 95

91

EP 4 636 424 A1

**EP 4 636 424 A1**

## INTERNATIONAL SEARCH REPORT

| | International application No. |
|---|---|
| | **PCT/JP2023/044242** |

| A. | CLASSIFICATION OF SUBJECT MATTER |
|---|---|

*G01R 31/52*(2020.01)i
FI: G01R31/52

According to International Patent Classification (IPC) or to both national classification and IPC

| B. | FIELDS SEARCHED |
|---|---|

Minimum documentation searched (classification system followed by classification symbols)

G01R31/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2005-304148 A (HITACHI INDUSTRIAL EQUIPMENT SYSTEMS CO LTD) 27 October 2005 (2005-10-27) | 1-11 |
| A | JP 2006-349424 A (ATOJI, Toyotsugu) 28 December 2006 (2006-12-28) | 1-11 |
| A | JP 2018-128270 A (HITACHI INDUSTRIAL EQUIPMENT SYSTEMS CO LTD) 16 August 2018 (2018-08-16) | 1-11 |
| A | JP 2017-20913 A (HITACHI INDUSTRIAL EQUIPMENT SYSTEMS CO LTD) 26 January 2017 (2017-01-26) | 1-11 |
| A | WO 2013/187166 A1 (ELM INC.) 19 December 2013 (2013-12-19) | 1-11 |
| A | JP 2021-83293 A (PANASONIC IP MAN CORP) 27 May 2021 (2021-05-27) | 1-11 |

☐ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 January 2024** | **30 January 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2023/044242**

| Patent document cited in search report | | | Publication date (day/month/year) | Patent family member(s) | | | Publication date (day/month/year) |
|---|---|---|---|---|---|---|---|
| JP | 2005-304148 | A | 27 October 2005 | US | 2005/0225909 | A1 | |
| | | | | CN | 1680821 | A | |
| JP | 2006-349424 | A | 28 December 2006 | US | 2009/0287430 | A1 | |
| | | | | WO | 2006/134678 | A1 | |
| | | | | EP | 1898225 | A1 | |
| JP | 2018-128270 | A | 16 August 2018 | (Family: none) | | | |
| JP | 2017-20913 | A | 26 January 2017 | (Family: none) | | | |
| WO | 2013/187166 | A1 | 19 December 2013 | US | 2015/0156842 | A1 | |
| | | | | CN | 104396347 | A | |
| JP | 2021-83293 | A | 27 May 2021 | (Family: none) | | | |

Form PCT/ISA/210 (patent family annex) (July 2022)

**REFERENCES CITED IN THE DESCRIPTION**

**Patent documents cited in the description**

- JP 2005304148 A